Europäisches Patentamt

European Patent Office

Office européen des brevets

(19)

(11)  EP 0 905 851 A1

(12)  **EUROPEAN PATENT APPLICATION**

(43) Date of publication:
    **31.03.1999  Bulletin 1999/13**

(51) Int. Cl.$^6$: **H02H 9/04**, H03K 17/0812

(21) Application number: **97830485.5**

(22) Date of filing: **30.09.1997**

(84) Designated Contracting States:
    **AT BE CH DE DK ES FI FR GB GR IE IT LI LU MC
    NL PT SE**
    Designated Extension States:
    **AL LT LV RO SI**

(71) Applicant:
    **STMicroelectronics S.r.l.
    20041 Agrate Brianza (Milano) (IT)**

(72) Inventor: **Ravanelli, Enrico M.A.
    20052 Monza (Milano) (IT)**

(54)   **Protection circuit for an electric pulse supply line in a semiconductor integrated device**

(57)   A protection circuit for a power supply line
(VDD) of the pulsive type in a monolithically integrated
semiconductor device provided with a second power
supply line (LV RAIL) of the low DC voltage type.

A field-effect transistor, connected between the line
(VDD) to be protected and ground (GND), with its gate
terminal being connected to ground through a resistor
(RG), has its gate terminal coupled to the second sup-
ply line (LV RAIL) through a switching circuit having a
preset delay.

FIG.  3

FIG.  2

EP 0 905 851 A1

Printed by Xerox (UK) Business Services
2.16.7/3.6

## Description

This invention relates generally to protection elements or circuits for the terminals of an integrated circuit in which they are included, and particularly to a protection circuit for a terminal of an electric power supply line of the pulsive type.

Circuits integrated with MOS technology, and more generally low voltage supply portions of devices integrated with technologies of the mixed type, as are the logic circuits included in such devices, may indeed suffer serious damage from electrostatic discharges (ESDs) to any of their terminals.

As concerns electrostatic discharges, it is a recognized fact that the terminals of an integrated circuit are likely to incidentally contact electrically charged objects, both during their fabrication and mounting to a circuit assembly, such that differences of potential, even of considerable magnitude, are created for instance between the gate electrodes of their input transistors, or the drain regions of their output transistors, and the substrate of semiconductor material wherein the integrated circuit is formed. In the former case, upon the difference of potential exceeding the dielectric strength threshold of the gate insulation, the transistor is put out of use by the electrostatic discharge which establishes through the insulation, while in the latter, a similar destructive effect occurs as the difference of potential exceeds the reverse breakdown threshold of the drain junction.

Also by way of example, in a CMOS integrated circuit fabricated with 1.2μm technology (i.e., with minimum gate dimensions of 1.2μm), the breakdown voltage may be 12-14V for the input transistors, and approximately 12V for the output transistors.

Several ways of protecting the various input, output, and supply terminals from electrostatic discharges are known.

In many cases, protectors using lateral bipolar transistors have been successfully employed.

A known protection device, specially adapted for monolithic integration to a MOS-type integrated circuit to be protected, is described in Italian Patent Application No. 26063 A/80 by this Applicant, for example.

This prior device comprises essentially a lateral NPN transistor having its emitter and collector doped with impurities of the N type, simultaneously and identically with the source and drain regions of the IGFETs in the MOS circuit to be protected, and having its inaccessible base heavily and deeply doped with acceptor ions (P-type impurities) by ion implantation.

An improved utilization of the same structure is described in Italian Patent Application No. 23077A/85 by the Applicant. The protector comprises first and second lateral bipolar transistors having their collector terminals respectively connected to the input terminal of the circuit and to the gate terminals of the IGFETs, and having their emitter terminals jointly connected to a ground terminal, a diffused resistor (R') interconnecting the collectors of both lateral transistors.

The width of the base of the first transistor and the concentration of the impurities in the bases of both lateral transistors are arranged to hold the negative resistance phenomena trigger voltage of the first lateral transistor and the breakdown voltage of the second lateral transistor at a lower value than the breakdown voltage of the gate isolation oxides and the breakdown voltage of the bipolar junctions included in the integrated circuit, as well as to hold the sustaining voltage of the first lateral transistor at a higher value than the integrated circuit supply voltage.

A simple, yet effective prior protection against electrostatic discharges can also be a bipolar transistor, having its base and emitter shortcircuited, which is connected between the terminal to be protected and ground.

The transistor will then exhibit a current/voltage characteristic of the bistable type between a high-impedance, high-voltage state designated BVcbo in the pertinent art, and a low-impedance, low-voltage state designated BVcer.

The transistor operates in the first-mentioned mode during normal operation of the circuit, without affecting it, but on the occurrence of an electrostatic discharge is forced to operate in the last-mentioned mode, thereby opening a path to ground for the discharge pulse.

The effectiveness of these types of protectors employing bipolar transistors is greatly diminished where it is a supply terminal or line that requires to be protected. In fact, BVcbo and BVcer may have statistic process variations which result in inconsistent true values with the circuit operation requirements, in the instance of a terminal or line at maximum potential being provided in the integrated circuit.

In addition, the voltage noise on a supply line to be protected may turn on the bipolar protection transistor, which would then clamp the supply voltage on BVcer, i.e. a much lower value than anticipated for powering the circuit.

This can not only be a cause of circuit malfunction, but also of permanent damage from a large DC current being flowed through the circuit.

European Patent Application No. 96830664.7 by the Applicant discloses an ESD protection circuit advantageously intended for a power supply terminal or line.

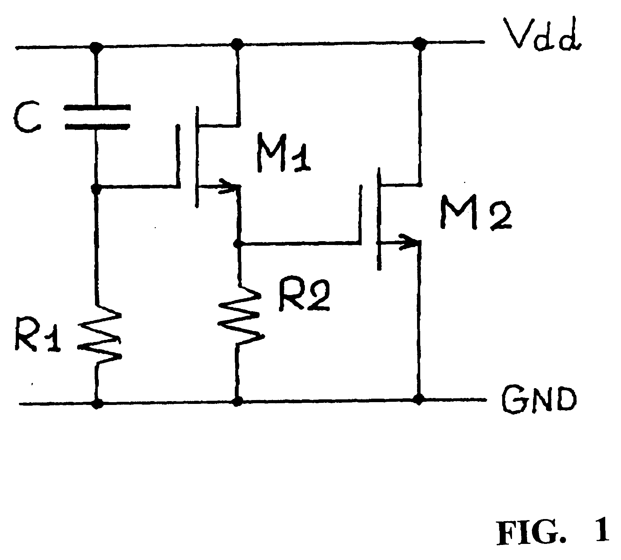

The last-mentioned protection circuit, for which a diagram is provided in Figure 1, comprises a first field-effect transistor M1 having its gate and source terminals connected to a ground GND through first and second resistors R1 and R2, respectively, and having its drain terminal connected to the supply line Vdd to be protected.

The circuit further comprises a second field-effect transistor M2, being connected between ground and the supply line with its source and drain terminals, respectively, and having its gate terminal connected to the source terminal of the transistor M1.

The Figure also shows a capacitor C, connected between the gate terminal and the drain terminal of the transistor M1. The protective function could, however, be ensured already by the intrinsic capacitance which exists between the gate and the drain of the transistor M1 itself.

The circuit described above is a dynamic circuit which becomes activated only by transient conditions, and reveals no dangerous latch-up side actions.

However, where the power supply is a pulsive type (also referred to as chopper type in the literature), the last-described protection circuit is unable to provide an effective protection for the line, while the other solutions previously described may cause malfunctioning of the whole circuit, possibly of an irreversible nature, or even destructive phenomena. where the supply on/off switching transistors have comparable rates (d voltage/d time) to that of the electrostatic discharge transients.

In this case, conventional protectors fail to discriminate electrical transients which happen to be similar but tied to different events.

The underlying technical problem of this invention is to provide an effective active protection against electrostatic discharges for the terminals of a pulsive-type power supply line in an integrated circuit.

This technical problem is solved by a protection circuit as previously indicated and defined in the characterizing portion of the appended claims to this specification.

The features and advantages of a protection circuit according to the invention will be apparent from the following description of an embodiment thereof, given by way of non-limitative example with reference to the accompanying drawings.

In the drawings:

Figure 1 shows a prior protection circuit as mentioned in the foregoing,

Figure 2 shows a schematic diagram for a protection circuit according to the invention, and

Figure 3 shows a circuit diagram for the characterizing portion of a protection circuit according to the invention.

The principle on which the invention is based is that of using, for ESD protection of a pulsive-type power supply line, or of a terminal thereof, a circuit which actively disables the protection while the device is under power in normal operation, and enables the active protection while the device is being handled and, therefore, not under power.

A pulsive state, or chopper, power supply is usually employed in integrated circuit devices for power stages, because it affords high efficiency combined with a low dissipation of power. The maximum value of the voltage VDD may be high.

On this account, such devices include a second supply line, LV RAIL, for powering that circuitry portion which can be said to serve control functions, e.g. of the CMOS type in devices which are integrated by processes of the mixed type.

This dedicated supply line is at a voltage LV, relative to the ground GND, which is low and constant. Usually, it is protected against electrostatic discharges by one of the prior solutions previously described.

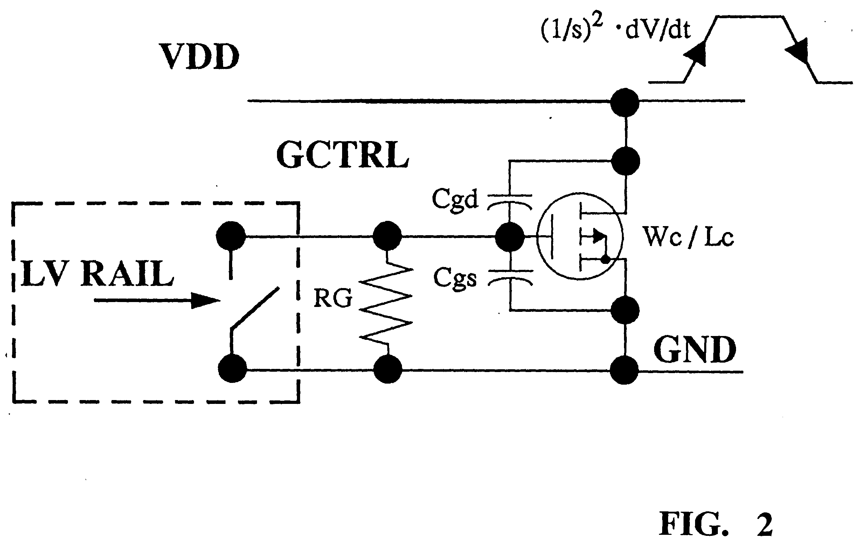

As shown in Figure 2, a circuit according to this invention also utilizes a field-effect transistor, GCTRL, which is here of the MOS type, connected between the pulsive supply line, VDD, to be protected and the ground GND with its drain and source terminals, respectively.

The gate terminal of the transistor is connected to ground, through a resistor RG and a capacitor CT in parallel with each other, and connected to the low voltage supply line LV RAIL through a bias current generator IBIAS.

The supply line LV RAIL is to be regulated and protected against ESD events by a dedicated protection, as mentioned.

This solution ensures that the gate terminal of the transistor MDRV will always be grounded during an ESD event as may be caused essentially by a power failure. In this case, the transistor MDRV would be turned off, and the gate impedance of the active protection controlled by the resistor RG.

In normal operation with the circuit biased, the gate terminal of the transistor MDRV is forced to the voltage of the supply line LV RAIL. In this condition, the transistor MDRV would be turned on, and the gate of the active protection transistor GCTRL be grounded, thereby disabling the protection.

The time constant $R_T C_T$ should be selected much higher than the characteristic time constant

$\mathbf{tau}_{ESD}$ of the electrostatic discharge. Then, the gate impedance of the transistor MDRV will be almost nil during the ESD event.

The dimensioning of the transistor MDRV should be such that:

$$R_{dS} << R_G \text{ and } R_{ds} * C_{dg} << \frac{V_T}{(dV/dt)}$$

In this way, it can be ensured that the active clamp will never be activated in normal operation by a supply transient with a rate equal dV/dt.

Thus, by suitably dimensioning both the time constant $R_T C_T$ and the transistor MDRV, the degree of immunity of the active protection in a pulsive supply condition can be greatly enhanced, without impairing the efficient operation of the protection in an electrostatic discharge situation.

It should be understood that modifications or substitutions may be made unto the embodiment described above, in manner known to the skilled persons in the art.

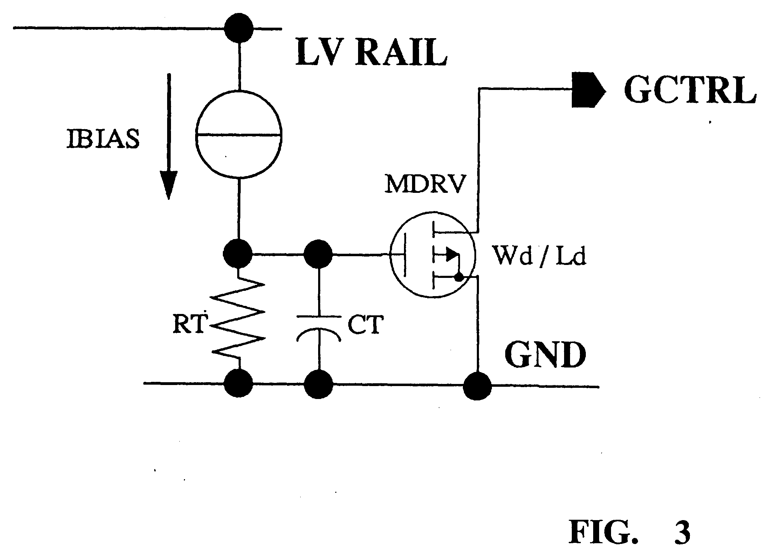

The circuit of Figure 3 can also be used in conjunction with the conventional circuit shown in Figure 1.

It will be sufficient for the purpose that a second field-effect transistor be added to the transistor MDRV, with the source and gate terminals of both transistors in common.

Thus, the drain terminal of the transistor MDRV will be connected to the gate terminal of the secondtransistor M2, while the drain terminal of the latter will be connected to the gate terminal of the transistor M1.

In this case, the capacitor C becomes unnecessary.

**Claims**

1.  A protection circuit for a power supply line (VDD) of the pulsive type in a monolithically integrated semiconductor device provided with a second power supply line (LV RAIL) of the low DC voltage type, comprising a first field-effect transistor (GCTRL) connected between the pulsive-type power supply line (VDD) and a ground (GND) with a drain terminal and a source terminal, respectively, and connected to ground with a gate terminal through a first resistor (RG), characterized in that the gate terminal of the first field-effect transistor (GCTRL) is coupled to said second power supply line (LV RAIL) through a switching circuit having a preset delay.

2.  A protection circuit according to Claim 1, characterized in that the preset delay switching circuit comprises a second field-effect transistor (MDRV) connected between the gate terminal of the first transistor (GCTRL) and the ground (CND) with a drain terminal and a source terminal, respectively, and connected to said second power supply line through a current generator (IBIAS) with a gate terminal which is also connected to ground through a resistive element (RZTZ) and a capacitive element (CT) in parallel with each other.

3.  A protection circuit according to any of Claims 1 and 2, characterized in that the first and second transistors are of the VDMOS type, and said second power supply line is a supply line to CMOS components.

FIG. 1

**VDD**

**GCTRL**

$(1/s)^2 \cdot dV/dt$

LV RAIL

$R_G$

$C_{gd}$

$C_{gs}$

$W_c/L_c$

**GND**

**FIG. 2**

EP 0 905 851 A1

FIG. 3

EP 0 905 851 A1

**European Patent Office**

## EUROPEAN SEARCH REPORT

Application Number

EP 97 83 0485

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | WO 96 18240 A (PHILIPS ELECTRONICS NV ;PHILIPS NORDEN AB (SE)) * abstract * --- | 1-3 | H02H9/04 H03K17/0812 |
| Y | EP 0 435 047 A (NAT SEMICONDUCTOR CORP) * column 5, line 31 - line 48; figure 5 * ----- | 1-3 | |

TECHNICAL FIELDS SEARCHED (Int.Cl.6)

H02H
H03K

The present search report has been drawn up for all claims

| Place of search | Date of completion of the search | Examiner |
|---|---|---|
| THE HAGUE | 19 February 1998 | Salm, R |

EPO FORM 1503 03.82 (P04C01)